# EUROPEAN PATENT APPLICATION

(11) **EP 1 420 454 A2**
(43) Date of publication of application: **19.05.2004**
(21) Application number: 03078441.7
(22) Date of filing: 03.11.2003
(51) Int. Cl.: H01L 27/148

(54) **A method for creating a double transparent electrode pseudo two-phase ccd**

(30) Priority: 13.11.2002 US 293652
(71) Applicant: EASTMAN KODAK COMPANY, Rochester, New York 14650 (US)
(72) Inventor: Fullerton, Daniel B. Eastman Kodak Company, Rochester New York 14650-2201 (US); Summa, Joseph R. Eastman Kodak Company, Rochester New York 14650-2201 (US)
(74) Representative: Haile, Helen Cynthia

(57) **Abstract**

A method of manufacturing a charge-coupled device, the method includes the steps of providing a substrate; covering the substrate with a single gate dielectric or a gate dielectric stack; covering the dielectric with a conducting material; depositing a second dielectric on the conducting material; etching the second dielectric and the conducting material in selected regions; depositing a third dielectric on the both the etched away and non-etched away regions; etching the third dielectric such that a portion of the third dielectric remains on a sidewall of the etched away portions which forms a gap region; and depositing a second conducting material in the gap region.

## Description

The invention relates generally to the field of image sensors, and more particularly, to a method of creating an image sensor having a transparent conducting oxide over all light sensing regions.

Solid state imagers utilizing charge coupled devices (CCD's) require high sensitivity to incoming light across the visible spectrum in order to provide optimum quantum efficiency. These devices generate charge in semiconductor pixels and transport them by line and column shift registers into an output circuit, as is well known in the art. It is essential that this charge transfer occur with a minimum of loss, facilitated by highly accurate edge alignment between the doped regions of the substrate and the overlying electrodes.

In the prior art, CCD image sensors frequently use polysilicon-conducting layers. These layers are known to have undesirable light absorption characteristics, especially in the blue region of the spectrum. This is undesirable because it limits the efficiency of the sensor.

Several approaches have been proposed to improve the blue response in CCD image sensors, such as that described in U.S. Patent No. 4,141,024 (Kano et al) in which partial gaps are formed between adjacent polysilicon electrodes, allowing light to enter the substrate more directly. This has the disadvantage, however, of providing a varying spectral response across an image-sensing site.

Alternate approaches using transparent conducting oxides for one electrode have been proposed (U.S. Patent Nos. 3,941,630 Larrabee; 4,394,675 Anagnostopoulos et al). These approaches reduce the unwanted absorption by replacing one phase of the polysilicon with a transparent conducting oxide, but still leave unwanted blue absorption due to the remaining polysilicon phases.

All-TCO-electrode devices as described by Losee in U.S. Patent No. 5,891,752 and Kosman et al. in U.S. Pat. No. 5,114,872 alleviate the problem of unwanted blue absorption by using only TCO electrodes while retaining highly efficient charge transfer by using self-aligned barrier implants, but at the cost of substantial manufacturing complexity.

Consequently, a need exists for a simple method for creating a pseudo-two-phase CCD image sensor utilizing all TCO electrodes and barrier regions in the substrate self-aligned to the edges of the electrodes providing high quantum efficiency across the visible portion of the electromagnetic spectrum and a high charge transfer efficiency through the shift registers of the imager. The present invention is directed to providing this need.

The present invention is directed to overcoming one or more of the problems set forth above. Briefly summarized, according to one aspect of the present invention, the invention resides in a method of manufacturing a charge-coupled device, the method comprising the step of (a) providing a substrate; (b) covering the substrate with a single gate dielectric or a gate dielectric stack; (c) covering the dielectric with a conducting material; (d) depositing a second dielectric on the conducting material; (e) etching the second dielectric and the conducting material in selected regions; (f) depositing a third dielectric on the both the etched away and non-etched away regions; (g) etching the third dielectric such that a portion of the third dielectric remains on a sidewall of the etched away portions which forms a gap region; and (h) depositing a second conducting material in the gap region.

These and other aspects, objects, features and advantages of the present invention will be more clearly understood and appreciated from a review of the following detailed description of the preferred embodiments and appended claims, and by reference to the accompanying drawings.

The present invention has the following advantage of providing a method of producing an image sensor having a transparent conducting oxide over all light sensing regions. Another advantage is a method of creating a self-aligned barrier region that facilitates efficient charge transfer in the device and allows operating modes that minimize dark current.
Fig. 1 is a view in vertical cross section of one step in the method of creating the image sensor of the present invention;
Fig. 2 is a view in vertical cross section of another step in the method of creating the image sensor of the present invention;
Fig. 3 is a view in vertical cross section of another step in the method of creating the image sensor of the present invention;
Fig. 4 is a view in vertical cross section of another step in the method of creating the image sensor of the present invention; and
Fig. 5 is a view in vertical cross section of one step in the method of creating the image sensor of the present invention.

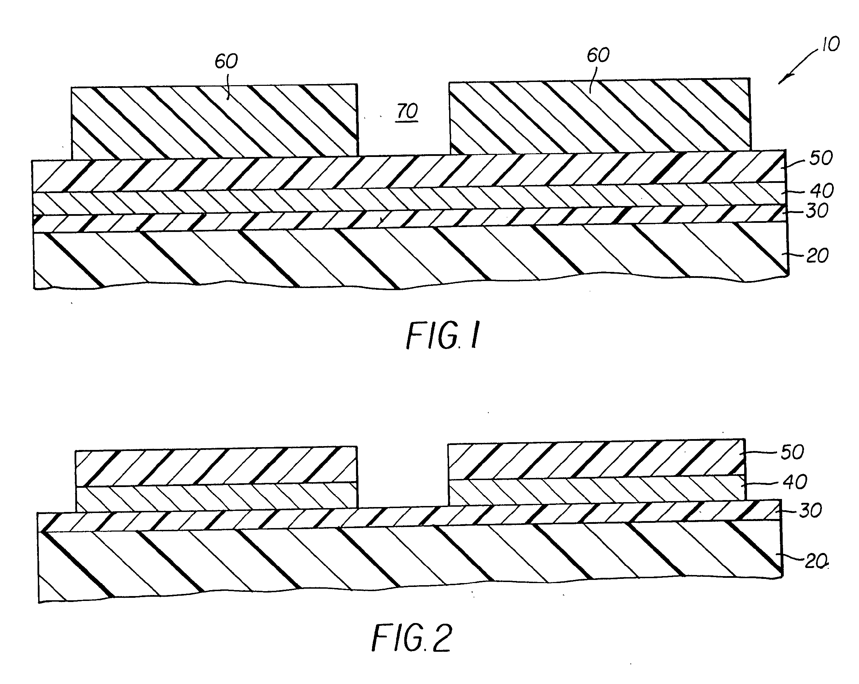

Referring to Fig. 1, there is shown a portion of an image sensor 10 that is formed during an initial step in creating an image sensor. This initial portion of an image sensor includes a substrate 20 having a gate dielectric 30, or alternatively multiple dielectric films (not shown), deposited thereon. A transparent conducting oxide 40 is deposited on the gate dielectric 30. An insulating layer 50 is deposited on the transparent conducting oxide 40. Photoresist 60 is applied and selectively removed forming a plurality of photoresist portions 60 having areas 70 therebetween.

Referring to Fig. 2, etching is performed on the top insulating layer 50, the transparent conducting oxide 40 and optionally through all, part or none of the gate dielectric 30 through the areas between the photoresist portions. In Fig. 2, the gate dielectric 30 is not etched. The plurality of photoresist portions 60 are then removed, as illustrated therein.

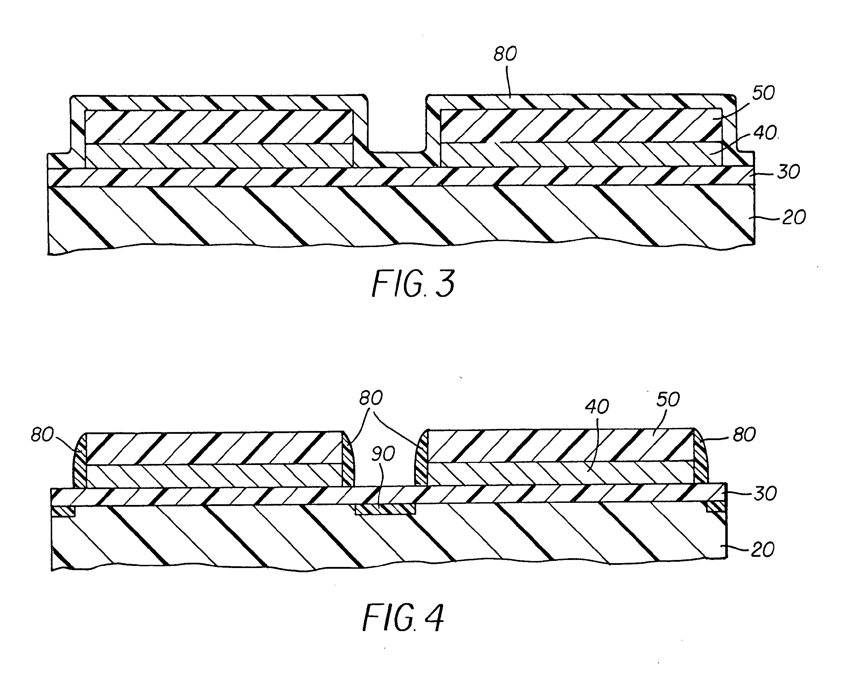

Referring to Fig. 3, if the gate dielectric 30 has been etched, then this portion may be reformed. In Fig. 3, the gate dielectric 30 has not been etched. Another insulating layer 80, preferably silicon dioxide, is substantially conformally deposited thereon.

Referring to Fig. 4, the insulating layer 50 is anisotropically etched clearing the conforming insulating layer material 80 from the horizontal surfaces, but not the vertical surfaces. A barrier region 90 is formed by selectively doping regions in the substrate through the previously etched regions. It facilitates understanding to note that, if the gate dielectric has been etched, this portion may be reformed.

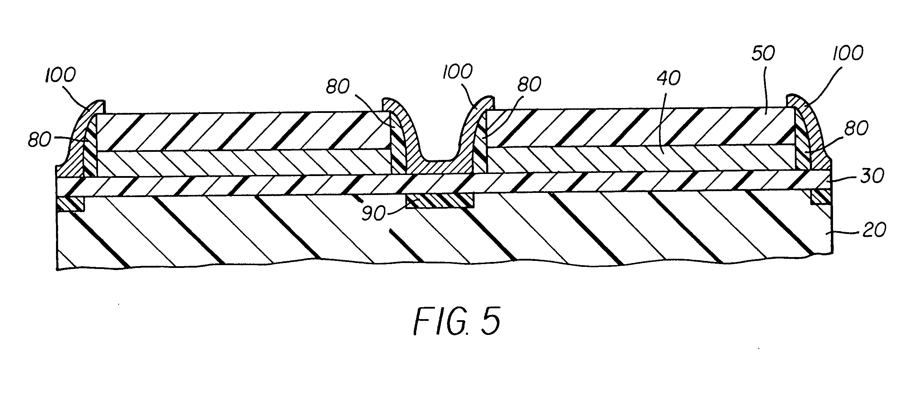

Referring to Fig. 5, a second transparent conducting oxide 100 is deposited and selectively removed into a desired configuration using patterning and etch processes which are well known in the art. It also facilitates understanding to note that the image sensor 10 includes additional steps for forming a typical commercial usable sensor. These steps are well known in the art and are not shown herein.

## Claims

1. A method of manufacturing a charge-coupled device, the method comprising the step of:
(a) providing a substrate;
(b) covering the substrate with a single gate dielectric or gate dielectric stack;
(c) covering the dielectric with a conducting material;
(d) depositing a second dielectric on the conducting material;
(e) etching the second dielectric and the conducting material in selected regions;
(f) depositing a third dielectric on the both the etched away and non-etched away regions;
(g) etching the third dielectric such that a portion of the third dielectric remains on a sidewall of the etched away portions which forms a gap region; and
(h) depositing a second conducting material in the gap region.

2. The method as in claim 1 further providing transparent conducting oxide as the conducting material.

3. The method as in claim 1 further comprising the step of placing an impurity into the gap region prior to step (h) to form a barrier region in the substrate.

4. The method as in claim 1 further comprising the step of, prior to step (h), forming all or a part of a second gate dielectric or gate dielectric stack in the gap region.
